# EUROPÄISCHE PATENTSCHRIFT

(11) **EP 4 260 421 B1**
(45) Veröffentlichungstag und Bekanntmachung des Hinweises auf die Patenterteilung: **04.12.2024**
(21) Anmeldenummer: 21801414.0
(22) Anmeldetag: 14.10.2021
(51) Int. Cl.: H02B 1/30, H05K 5/02, H05K 7/18

(54) **SCHALTSCHRANKANORDNUNG MIT EINER KABELEINFÜHRUNG**
SWITCHGEAR ARRANGEMENT WITH A CABLE INLET
APPAREILLAGE DE COMMUTATION AVEC UNE ENTRÉE DE CÂBLE

(30) Priorität: 14.12.2020 DE 202020107214 U
(43) Veröffentlichungstag der Anmeldung: 18.10.2023
(73) Patentinhaber: Rittal GmbH & Co. KG, 35745 Herborn (DE)
(72) Erfinder: HOBBS, Steven, 60489 Frankfurt-Rödelheim (DE); MAIDMENT, Barry, Southampton Hampshire SO30 0NW (GB)
(74) Vertreter: Angerhausen, Christoph
(86) Internationale Anmeldenummer: PCT/DE2021/100828
(87) Internationale Veröffentlichungsnummer: WO 2022/127967

(56) Entgegenhaltungen:
- DE-A1- 10 007 470
- NO-B1- 310 010
- - CHATSWORTH: "N-SERIES TERAFRAME RADIUS DROP", 29 October 2020 (2020-10-29), XP055876921, Retrieved from the Internet <URL:https://web.archive.org/web/20201029200551/https://www.chatsworth.com/en-us/products/cabinets-enclosures-containment/accessories/cable-management> [retrieved on 20220107]

## Beschreibung

Die Erfindung geht aus von einer Schaltschrankanordnung mit mindestens Schaltschrankgehäuse, das an seiner Oberseite eine Kabeleinführung aufweist, die ein Leitblech aufweist, entlang welchem mindestens ein Kabel, ein Leiter oder eine Leitung mit einem vorgegebenen Krümmungsradius in das Schaltschrankgehäuse eingeführt ist. Eine derartige Schaltschrankanordnung ist bekannt aus Chatsworth: "N-SERIES TERAFRAME RADIUS DROP", 29.Oktober 2020, XP055876921. Ähnliche Anordnungen beschreiben auch die DE 100 07 470 A1, die NO 310 010 B1 und die DE 198 117 52 C1.

Die bekannten Kabeleinführungen haben den Nachteil, dass sie nicht für die kabelschonende Einführung von Kabeln, Leitern, Leitungen und dergleichen in das Schaltschrankinnere geeignet sind. Dies ist bereits dadurch bedingt, dass die über die Oberseite und eine Kante der Kabeleinführung gebogenen, in das Schaltschrankgehäuse eingeführten Leitungen, beispielsweise elektrische Leiter, frei fallend eingeführt werden. Auch die geordnete Einführung erlauben die bekannten Kabeleinführungen nicht. Vielmehr erfolgt die Kabeleinführung in der Regel in Form eines ungeordneten Kabelbündels.

Es ist daher Aufgabe der Erfindung, eine Schaltschrankanordnung der eingangs beschriebenen Art derart weiterzuentwickeln, dass sie einerseits die materialschonende und andererseits die geordnete Kabeleinführung erlaubt.

Diese Aufgabe wird durch eine Schaltschrankanordnung mit den Merkmalen des Anspruchs 1 gelöst. Die abhängigen Ansprüche betreffen jeweils vorteilhafte Ausführungsformen der Erfindung.

Demgemäß ist vorgesehen, dass das Leitblech an eine Breiten- oder Tiefenstrebe eines rechteckigen horizontalen Dachrahmens eines Rahmengestells des Schaltschrankgehäuses angeformt ist oder die Breiten- oder Tiefenstrebe ersetzt. Der Krümmungsradius kann etwa abhängig von den Querschnitten und Materialien der eingeführten Leiter, Leitungen und dergleichen derart gewählt sein, dass eine Beschädigung dieser wirkungsvoll vermieden wird.

Mit Hilfe der Kabeleinführung kann beispielsweise ein sich über die gesamte Breite oder Tiefe des Dachelements des Schaltschrankgehäuses erstreckender Einführspalt geschaffen werden, sodass eine Vielzahl Leiter nebeneinander und insofern geordnet entlang des vorgegebenen Krümmungsradius und damit materialschonend in das Schaltschrankgehäuse eingeführt werden können.

Das mindestens eine Kabel, der mindestens eine Leiter oder die mindestens eine Leitung können entlang des Leitblechs aus der Horizontalen in die Vertikale geführt sein. Das Leitblech kann insbesondere eine im Vertikalquerschnitt kreissegmentförmige 90°-Führung aufweisen.

Das Leitblech kann als eine horizontale Breitenstrebe oder als eine horizontale Tiefenstrebe ausgebildet sein. Diese kann sich zwischen gegenüberliegenden Profilstreben eines Rahmengestells des Schaltschrankgehäuses erstrecken. Alternativ kann die Breitenstrebe oder die Tiefenstrebe auch eine Profilstrebe des Rahmengestells ersetzen. Beispielsweise kann vorgesehen sein, dass das Leitblech an eine derartige Profilstrebe des Rahmengestells angeformt ist.

Die Breitenstrebe oder die Tiefenstrebe kann an den gegenüberliegenden Profilstreben zugewandten Befestigungsflanschen Befestigungsmittel aufweisen, über die die Breitenstrebe oder die Tiefenstrebe in die jeweilige Profilstrebe des Rahmengestells eingehängt ist.

Die Befestigungsmittel können in eine Systemlochung aus regelmäßig beabstandeten Befestigungsaufnahmen der Profilstreben eingreifen, sodass die Befestigungsposition des Leitblechs in Bezug auf das Rahmengestell variabel ist. Dies kann zur Variation der Position der Kabeleinführung und/oder zur Variation eines lichten Öffnungsmaßes eines Einführspalts der Kabeleinführung verwendet werden.

Die Befestigungsmittel können Befestigungsmittel für die Vorpositionierung des Leitblechs in Bezug auf das Rahmengestell und Befestigungsmittel für die kraftschlüssige Verbindung des Leitblechs an dem Rahmengestell aufweisen. Die beiden Arten Befestigungsmittel können als dasselbe Befestigungsmittel ausgebildet sein.

Die Mittel für die kraftschlüssige Verbindung können einen Durchbruch in dem Befestigungsflansch aufweisen, der mit einem vorzugsweise geometrisch identisch ausgebildeten Durchbruch der Systemlochung des Rahmengestells fluchtet. Dabei kann durch die fluchtenden Durchbrüche des Befestigungsflanschs und des Rahmengestells ein Rastverbinder eingesteckt sein.

Das Leitblech kann mit einem gegenüberliegenden Begrenzungselement einen Einführspalt der Kabeleinführung begrenzen.

Das gegenüberliegende Begrenzungselement kann ein weiteres Leitblech sein, welches spiegelsymmetrisch zum ersten Leitblech ausgerichtet ist, sodass Kabel, Leiter, oder Leitungen von gegenüberliegenden Seiten dem Einführspalt entlang einer jeweiligen Krümmung des jeweiligen Leitblechs zugeführt werden können.

Das weitere Leitblech kann einteilig an ein Dachblech des Schaltschrankgehäuses angeformt oder als eine Umkantung des Dachblechs bereitgestellt sein. Dabei kann die Umkantung dem Leitblech zugewandt ausgebildet sein.

Das Leitblech und/oder das weitere Leitblech können einen Krümmungsradius in Vertikalebene aufweisen, der mindestens 0,5 cm und bevorzugt mindestens 1 cm beträgt.

Auf einer freien horizontalen Kante des Leitblechs, die sich bei einer Breitenstrebe in Breitenrichtung und bei einer Tiefenstrebe in Tiefenrichtung des Schaltschrankgehäuses erstreckt und die einem Innenraum des Schaltschrankgehäuses zugewandt ist, kann eine Bürstenleiste aufgesteckt sein.

Eine Vielzahl Borsten der Bürstenleiste kann sich dabei in horizontaler Richtung erstrecken. Beispielsweise können sich die Borsten der Bürstenleiste senkrecht zu einer Einsteckrichtung einer Aufstecknut der Bürstenleiste, mit der die Bürstenleiste auf eine freie Längskante eines Leitblechs aufgesteckt ist, erstrecken.

Eine weitere Bürstenleiste kann auf ein weiteres Leitblech an einem Dachblech des Schaltschrankgehäuses aufgesteckt sein. Dabei können sich die beiden Bürstenleisten gegenüberstehend mit ihren freien Enden einander zugewandt und vorzugsweise aneinandergrenzend angeordnet sein.

Weitere Einzelheiten der Erfindung werden anhand der nachstehenden Figuren erläutert. Dabei zeigt:
- Figur 1: eine perspektivische Draufsicht auf eine Ausführungsform einer erfindungsgemäßen Schaltschrankanordnung;
- Figur 2: einen Ausschnitt einer perspektivischen Draufsicht auf eine weitere Ausführungsform der Erfindung;
- Figur 3: eine angeschnittene Darstellung noch einer weiteren Ausführungsform einer erfindungsgemäßen Schaltschrankanordnung;
- Figur 4: eine Seitenansicht einer erfindungsgemäßen Schaltschrankanordnung; und
- Figur 5: eine Breitenstrebe oder Tiefenstrebe gemäß einer Ausführungsform der Erfindung.

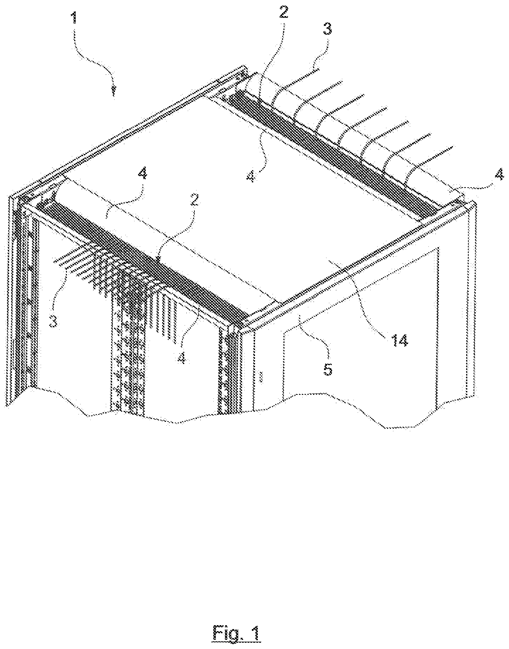

Die Figur 1 veranschaulicht die Vorteile erfindungsgemäßer Schaltschrankanordnungen gegenüber den aus dem Stand der Technik bekannten. Die erfindungsgemäße Anordnung erlaubt es, die Kabeleinführung 2 über die gesamte Tiefe des Schaltschrankrahmengestells auszubilden, sodass in Tiefenrichtung des Schaltschrankgehäuses nebeneinander verschiedene Leitungen geordnet eingeführt werden können. Aufgrund des Krümmungsradius der Leitbleche 4 erfolgt die Kabeleinführung zudem materialschonend, sodass Kabelbrüche und dergleichen wirkungsvoll vermieden werden können.

In der Figur 1 ist ebenfalls zu erkennen, dass die Leitbleche eine Profilstrebe des Rahmengestells 6 des Schaltschrankgehäuses 1 ersetzen können, im vorliegenden Fall gegenüberliegende Tiefenstreben des Dachrahmens des Rahmengestells 1. Die Kabeleinführungen 2 werden folglich zwischen einem mittig zwischen den Leitblechen 4 angeordnetem Dachblech 14 sowie den beiden äußeren Leitblechen 4 gebildet. Das Dachelement 14 kann ebenso den beiden äußeren Leitblechen 4 zugewandt an seinen gegenüberliegenden Kanten jeweils ein weiteres angeformtes Leitblech 4, beispielsweise in Form einer 90°-Umkantung mit einem Krümmungsradius von beispielsweise mehr als 0,5 cm, aufweisen. Mit Hilfe dieser zusätzlichen Leitbleche 4 am Dachblech 14 ist die kabelschonende und geordnete Kabeleinführung von Leitern möglich, die von einer gegenüberliegenden Seite des Schaltschrankgehäuses 1 über das Dachblech 14 hinweg in den Schaltschrankinnenraum eingeführt werden.

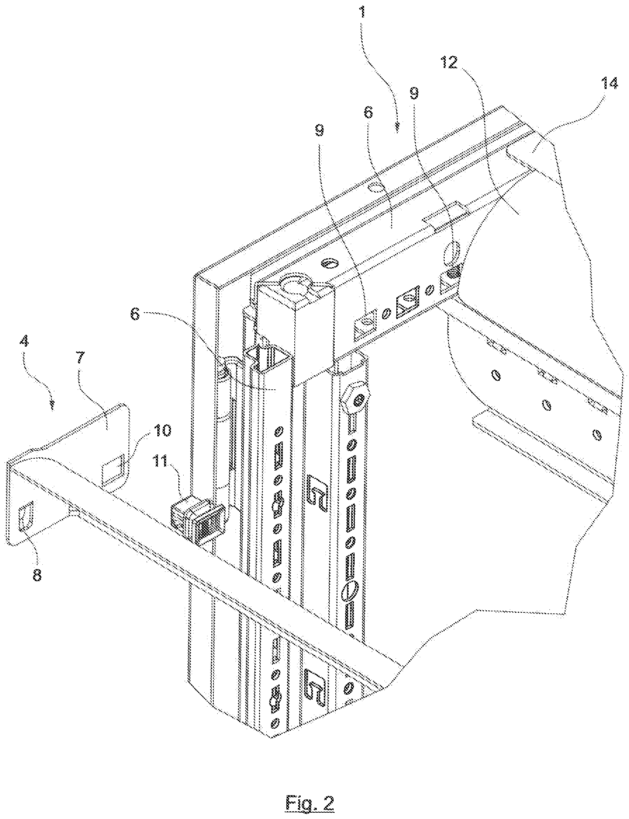

Die Figur 2 veranschaulicht eine Ausführungsform, bei der das Leitblech 4 eine Tiefenstrebe eines oberen Dachrahmens eines Schaltschrankgehäuses 1 ersetzt, in dem die Tiefenstrebe über Befestigungsmittel 8, 9, 10, 11 zwischen gegenüberliegenden Breitenstreben eines Dachrahmens des Schaltschrankgehäuses festgelegt wird. Die Befestigungsmittel 8, 9, 10, 11 weisen erste Befestigungsmittel 8, 9 für die formschlüssige Verbindung zwischen dem Flansch 7 und dem Rahmengestell 6 sowie zweite Befestigungsmittel 9, 10, 11 für die kraftschlüssige Verbindung des Flanschs 7 an dem Rahmengestell 6 auf. Mit Hilfe der ersten Befestigungsmittel 8, 9 für die formschlüssige Verbindung ist eine Vorpositionierung des Leitblechs 4 in Bezug auf das Rahmengestell 6 möglich, um mit Hilfe der zweiten Befestigungsmittel 10, 11 eine kraftschlüssige Verbindung herzustellen, wenn das Leitblech 4 eine gewünschte Position etwa in Bezug auf das Dachblech 14 einnimmt.

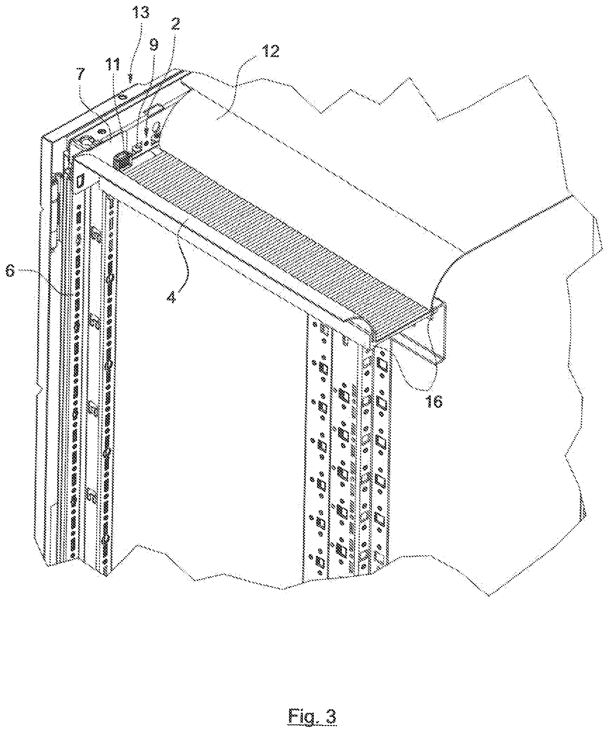

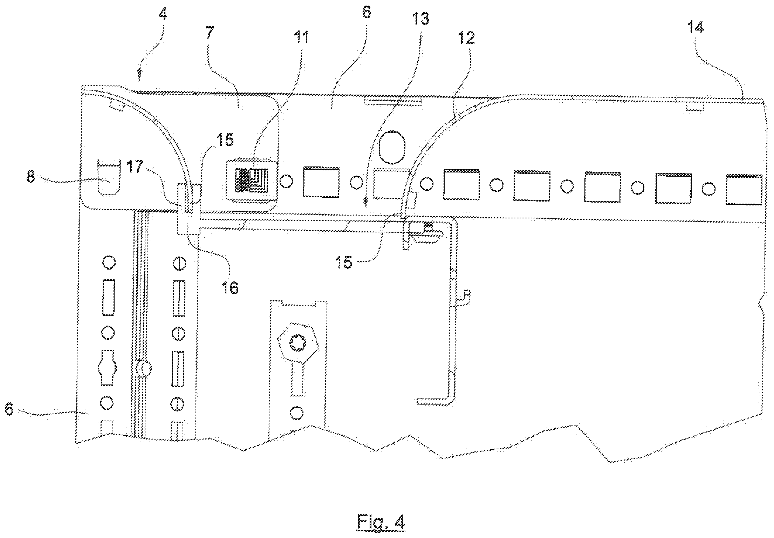

Das Dachblech 14 weist ein dem Leitblech 4 zugewandtes Begrenzungselement 12 auf, welches als ein weiteres Leitblech ausgebildet und spiegelsymmetrisch zu dem Leitblech 4 angeordnet ist. Aus einer Zusammenschau der Figuren 3 und 4 ist erkennbar, dass bei einer derartigen Anordnung des Leitblechs 4 in Bezug auf das Begrenzungselement 12 des Dachblechs 14 der Einführspalt 2 zwischen dem Leitblech 4 und dem Begrenzungselement 12 ausgebildet ist und grade durch das lichte Öffnungsmaß zwischen den freien Enden von dem Leitblech 4 und dem Begrenzungselement 12 definiert ist. In der aus dem Stand der Technik bekannten Weise können zur Vermeidung von Staubeintrag in das Schaltschrankinnere Bürstenleisten 16 vorgesehen sein, welche die Einführung 2 leiterdurchlässig verschließen.

Mit Bezug auf Figur 4 ist zu erkennen, dass die Bürstenleisten eine vertikale Einstecknut und sich senkrecht zur Einsteckrichtung der Nut erstreckende Borsten aufweisen, wobei jeweils eine Bürstenleiste 16 auf sowohl das Leitblech 4 als auch das Begrenzungselement 12, insbesondere auf deren horizontale freie Kanten aufgesteckt sein kann. Alternativ ist jedoch ebenfalls denkbar, dass lediglich auf eine der beiden genannten freien Kanten eine Bürstenleiste aufgesteckt ist, die das gesamte horizontale lichte Öffnungmaß der Kabeleinführung 2 verschließt.

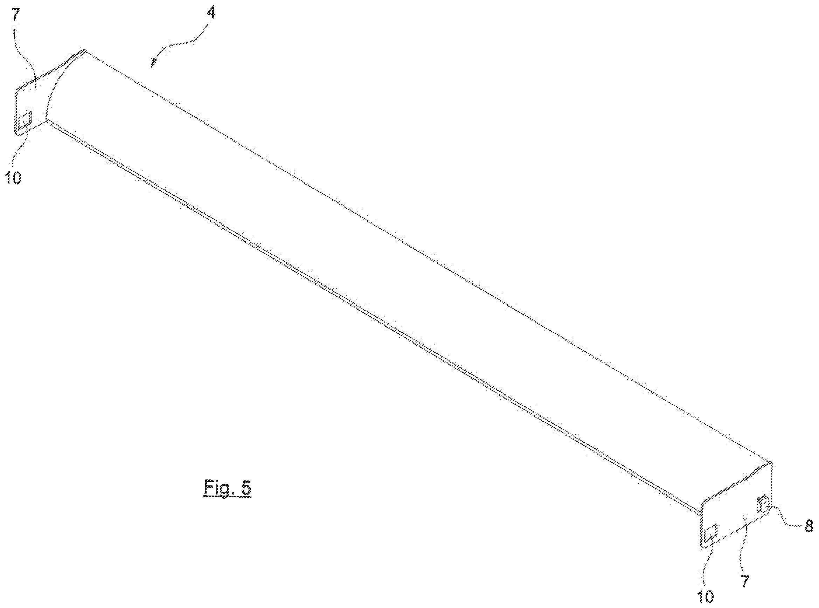

Die Figur 5 zeigt eine bespielhafte Ausführungsform eines Leitblechs 4, welches als einfaches Blechformteil ausgebildet sein kann. Insbesondere kann das Leitblech 4 aus einem zentralen, die Krümmung aufweisenden Blech gebildet sein, welches lediglich an seinen gegenüberliegenden Stirnseiten jeweils einen Flansch 7 für die Befestigung des Leitblechs am Rahmengestell des Schaltschrankgehäuses aufweist. Der Krümmungsradius sollte mindestens 0,5 cm betragen, um eine besonders schonende Kabeleinführung zu ermöglichen. Besonders bevorzugt beträgt der Krümmungsradius mehr als 1 cm.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

### Bezugszeichenliste:

- 1: Schaltschrankgehäuse
- 2: Kabeleinführung
- 3: Kabel
- 4: Leitblech
- 5: Profilstrebe
- 6: Rahmengestell
- 7: Befestigungsflansch
- 8: Befestigungsmittel
- 9: Systemlochung
- 10: Durchbruch
- 11: Rastverbinder
- 12: Begrenzungselement
- 13: Einführspalt
- 14: Dachblech
- 15: Kante
- 16: Bürstenleiste
- 17: Aufstecknut

## Patentansprüche

1. Schaltschrankanordnung mit mindestens einem Schaltschrankgehäuse (1), das an
seiner Oberseite eine Kabeleinführung (2) aufweist, die ein Leitblech (4) aufweist, entlang welchem mindestens ein Kabel (3), ein Leiter oder eine Leitung mit einem vorgegebenen Krümmungsradius in das Schaltschrankgehäuse (1) eingeführt ist, **dadurch gekennzeichnet, dass** das Leitblech (4) an eine Breiten- oder Tiefenstrebe eines rechteckigen horizontalen Dachrahmens eines Rahmengestells (6) des Schaltschrankgehäuses (1) angeformt ist oder die Breiten- oder Tiefenstrebe ersetzt.

2. Schaltschrankanordnung nach Anspruch 1, bei der das mindestens eine Kabel (3) der mindestens eine Leiter oder die mindestens eine Leitung entlang des Leitblechs (4) aus der Horizontalen in die Vertikale geführt ist.

3. Schaltschrankanordnung nach Anspruch 1 oder 2, bei der das Leitblech (4) als eine horizontale Breitenstrebe oder Tiefenstrebe ausgebildet ist, die sich zwischen gegenüberliegenden Profilstreben (5) eines Rahmengestells (6) des Schaltschrankgehäuses (1) erstreckt.

4. Schaltschrankanordnung nach Anspruch 3, bei der die Breitenstrebe oder die Tiefenstrebe an den gegenüberliegenden Profilstreben (5) zugewandten Befestigungsflanschen (7) Befestigungsmittel (8) aufweist, über die die Breitenstrebe oder die Tiefenstrebe in die jeweilige Profilstrebe des Rahmengestells (6) eingehängt ist.

5. Schaltschrankanordnung nach Anspruch 4, bei der die Befestigungsmittel (8) in eine Systemlochung (9) aus regelmäßig beabstandeten Befestigungsaufnahmen der Profilstreben (5) eingreifen, sodass die Befestigungsposition des Leitblechs (4) in Bezug auf das Rahmengestell (6) variabel ist.

6. Schaltschrankanordnung nach Anspruch 4 oder 5, bei der die Befestigungsmittel (8) Befestigungsmittel für die Vorpositionierung des Leitblechs (4) in Bezug auf das Rahmengestell (6) und Befestigungsmittel für die kraftschlüssige Verbindung des Leitblechs (4) an dem Rahmengestell (6) aufweist.

7. Schaltschrankanordnung nach Anspruch 6, bei der die Mittel für die kraftschlüssige Verbindung einen Durchbruch (10) in dem Befestigungsflansch (7) aufweisen, der mit einem vorzugsweise geometrisch identisch ausgebildeten Durchbruch der Systemlochung (9) des Rahmengestells (6) fluchtet, wobei durch die fluchtenden Durchbrüche des Befestigungsflanschs (7) und des Rahmengestells (6) ein Rastverbinder (11) eingesteckt ist.

8. Schaltschrankanordnung nach einem der vorangegangen Ansprüche, bei der das Leitblech (4) mit einem gegenüberliegenden Begrenzungselement (12) einen Einführspalt (13) der Kabeleinführung (2) begrenzt.

9. Schaltschrankanordnung nach Anspruch 8, bei der das gegenüberliegende Begrenzungselement (12) ein weiteres Leitblech ist, welches spiegelsymmetrisch zu dem ersten Leitblech (4) ausgerichtet ist, sodass Kabel (3), Leiter, oder Leitungen von gegenüberliegenden Seiten dem Einführspalt (13) entlang einer jeweiligen Krümmung des jeweiligen Leitblechs (4) zugeführt werden können.

10. Schaltschrankanordnung nach Anspruch 9, bei der das weitere Leitblech (4) einteilig an ein Dachblech (14) des Schaltschrankgehäuses (1) angeformt oder als eine Umkantung des Dachblechs (14) bereitgestellt ist.

11. Schaltschrankanordnung nach einem der vorangegangen Ansprüche, bei der das Leitblech (4) und/oder das weitere Leitblech einen Krümmungsradius in Vertikalebene aufweist/aufweisen, der mindestens 0,5 cm beträgt.

12. Schaltschrankanordnung nach einem der vorangegangen Ansprüche, bei der auf einer freien horizontalen Kante (15) des Leitblechs (4), die sich bei einer Breitenstrebe in Breitenrichtung und bei einer Tiefenstrebe in Tiefenrichtung des Schaltschrankgehäuse (1) erstreckt und die einem Innenraum des Schaltschrankgehäuses (1) zugewandt ist, eine Bürstenleiste (16) aufgesteckt ist.

13. Schaltschrankanordnung nach Anspruch 12, bei der sich eine Vielzahl Borsten der Bürstenleiste (16) in horizontaler Richtung erstrecken.

14. Schaltschrankanordnung nach Anspruch 12 oder 13, bei der sich die Borsten der Bürstenleiste (16) senkrecht zu einer Einsteckrichtung einer Aufstecknut (17) der Bürstenleiste (16) erstrecken.

15. Schaltschrankanordnung nach einem der Ansprüche 12 bis 14, bei der eine weitere Bürstenleiste (16) auf ein weiteres Leitblech (4) an einem Dachblech (14) des Schaltschrankgehäuses (1) aufgesteckt ist, wobei sich die beiden Bürstenleisten (16) gegenüberstehend mit ihren freien Enden einander zugewandt und vorzugsweise aneinandergrenzend angeordnet sind.

## Claims

1. Switchgear cabinet arrangement with at least one switchgear cabinet housing (1), which has a cable inlet (2) on its upper side, which has a guide plate (4), along which at least one cable (3), a conductor or a line with a predetermined radius of curvature is introduced into the switchgear cabinet housing (1), **characterised in that** the guide plate (4) is formed on a width or depth strut of a rectangular horizontal roof frame of a framework (6) of the switchgear cabinet housing (1) or replaces the width or depth strut.

2. Switchgear cabinet arrangement according to claim 1, in which the at least one cable (3), the at least one conductor or the at least one line is guided along the guide plate (4) from the horizontal into the vertical.

3. Switchgear cabinet arrangement according to claim 1 or 2, in which the guide plate (4) is formed as a horizontal width strut or depth strut, which extends between opposite profile struts (5) of a framework (6) of the switchgear cabinet housing (1).

4. Switchgear cabinet arrangement according to claim 3, in which the width strut or the depth strut has fastening means (8) on fastening flanges (7) facing the opposite profile struts (5), via which the width strut or the depth strut is suspended in the respective profile strut of the framework (6).

5. Switchgear cabinet arrangement according to claim 4, in which the fastening means (8) engage in a system hole (9) of regularly spaced fastening receptacles of the profile struts (5), so that the fastening position of the guide plate (4) is variable in relation to the framework (6).

6. Switchgear cabinet arrangement according to claim 4 or 5, in which the fastening means (8) has fastening means for the pre-positioning of the guide plate (4) in relation to the framework (6) and fastening means for the force-fitting connection of the guide plate (4) to the framework (6).

7. Switchgear cabinet arrangement according to claim 6, in which the means for the force-fitting connection have an aperture (10) in the fastening flange (7), which is aligned with a preferably geometrically identically formed aperture of the system hole (9) of the framework (6), wherein a latching connector (11) is inserted through the aligned apertures of the fastening flange (7) and of the framework (6).

8. Switchgear cabinet arrangement according to one of the preceding claims, in which the guide plate (4) delimits an insertion gap (13) of the cable insertion (2) with an opposite delimiting element (12).

9. Switchgear cabinet arrangement according to claim 8, in which the opposite delimiting element (12) is a further guide plate, which is aligned mirror-symmetrically to the first guide plate (4), so that cables (3), conductors or lines can be fed from opposite sides to the insertion gap (13) along a respective curvature of the respective guide plate (4).

10. Switchgear cabinet arrangement according to claim 9, in which the further guide plate (4) is formed in one piece on a roof plate (14) of the switchgear cabinet housing (1) or is provided as a folded edge of the roof plate (14).

11. Switchgear cabinet arrangement according to one of the preceding claims, in which the guide plate (4) and/or the further guide plate has/have a radius of curvature in the vertical plane which is at least 0.5 cm.

12. Switchgear cabinet arrangement according to one of the preceding claims, in which a brush strip (16) is plugged onto a free horizontal edge (15) of the guide plate (4), which extends in the width direction in the case of a width strut and in the depth direction of the switchgear cabinet housing (1) in the case of a depth strut and which faces an interior of the switchgear cabinet housing (1).

13. Switchgear cabinet arrangement according to claim 12, in which a plurality of bristles of the brush strip (16) extend in the horizontal direction.

14. Switchgear cabinet arrangement according to claim 12 or 13, in which the bristles of the brush strip (16) extend perpendicularly to an insertion direction of a plug-on groove (17) of the brush strip (16).

15. Switchgear cabinet arrangement according to one of claims 12 to 14, in which a further brush strip (16) is plugged onto a further guide plate (4) on a roof plate (14) of the switchgear cabinet housing (1), wherein the two brush strips (16) are arranged opposite one another with their free ends facing one another and preferably adjoining one another.

## Revendications

1. Disposition d'armoire de commande avec au moins un boîtier d'armoire de commande (1), qui comprend, sur son côté supérieur, une entrée de câbles (2), qui comprend une tôle de guidage (4) le long de laquelle au moins un câble (3), un conducteur ou une conduite avec un rayon de courbure prédéterminé est introduit dans le boîtier d'armoire de commande (1),
**caractérisée en ce que** la tôle de guidage (4) est formée sur une entretoise de largeur ou de profondeur d'un cadre de toit rectangulaire horizontal d'un châssis (6) du boîtier d'armoire de commande (1) ou remplace l'entretoise de largeur ou de profondeur.

2. Disposition d'armoire de commande selon la revendication 1, dans laquelle l'au moins un câble (3), l'au moins un conducteur ou l'au moins une conduite est guidé le long de la tôle de guidage (4) de l'horizontale à la verticale.

3. Disposition d'armoire de commande selon la revendication 1 ou 2, dans laquelle la tôle de guidage (4) est conçue comme une entretoise de largeur horizontale ou une entretoise de profondeur qui s'étend entre des entretoises profilées (5) opposées d'un châssis (6) du boîtier d'armoire de commande (1).

4. Disposition d'armoire de commande selon la revendication 3, dans laquelle l'entretoise de largeur ou l'entretoise de profondeur comprend, sur les brides de fixation (7) orientées vers les entretoises profilées (5) opposées, un moyen de fixation (8) par l'intermédiaire duquel l'entretoise de largeur ou l'entretoise de profondeur est accrochée dans l'entretoise profilée correspondante du châssis (6).

5. Disposition d'armoire de commande selon la revendication 4, dans laquelle les moyens de fixation (8) s'emboîtent dans une perforation de système (9) constituée de logements de fixation, disposés à des intervalles réguliers, des entretoises profilées (5), de sorte que les positions de fixation de la tôle de guidage (4) par rapport au châssis (6) peuvent être modifiées.

6. Disposition d'armoire de commande selon la revendication 4 ou 5, dans laquelle les moyens de fixation (8) comprennent des moyens de fixation pour le pré-positionnement de la tôle de guidage (4) par rapport au châssis (6) et des moyens de fixation pour la liaison par force de la tôle de guidage (4) avec le châssis (6).

7. Disposition d'armoire de commande selon la revendication 6, dans laquelle les moyens pour la liaison par force comprennent un perçage (10) dans la bride de fixation (7), qui est aligné avec un perçage, qui présente de préférence une forme géométrique identique, de la perforation du système (9) du châssis (6), dans lequel les perçages alignés de la bride de fixation (7) et du châssis (6) permettent d'enfichage d'un connecteur à encliquetage (11).

8. Disposition d'armoire de commande selon l'une des revendications précédentes, dans laquelle la tôle de guidage (4) limite, avec un élément de limitation (12) opposé, une fente d'introduction (13) de l'entrée de câbles (2).

9. Disposition d'armoire de commande selon la revendication 8, dans laquelle l'élément de limitation (12) opposé est une autre tôle de guidage qui est orientée, avec une symétrie en miroir par rapport à la première tôle de guidage (4) de sorte que les câbles (3), conducteurs ou conduites peuvent être introduits à partir des côtés opposés dans la fente d'introduction (13) le long d'une courbure respective de la tôle de guidage (4) correspondante.

10. Disposition d'armoire de commande selon la revendication 9, dans laquelle l'autre tôle de guidage (4) est formée d'une seule pièce avec une tôle de toit (14) du boîtier d'armoire de commande (1) ou est conçue comme un pliage de la tôle de toit (14).

11. Disposition d'armoire de commande selon l'une des revendications précédentes, dans laquelle la tôle de guidage (4) et/ou l'autre tôle de guidage présente un rayon de courbure dans le plan vertical qui est égal à 0,5 cm.

12. Disposition d'armoire de commande selon l'une des revendications précédentes, dans laquelle, sur une arête horizontale libre (15) de la tôle de guidage (4), qui s'étend, pour une entretoise de largeur, dans la direction de la largeur et, pour une entretoise de profondeur, dans la direction de la profondeur du boîtier d'armoire de commande (1) et qui est orientée vers un espace interne du boîtier d'armoire de commande (1), est enfichée une barrette à brosse (16).

13. Disposition d'armoire de commande selon la revendication 12, dans laquelle une pluralité de poils de la barrette à brosse (16) s'étend dans la direction horizontale.

14. Disposition d'armoire de commande selon la revendication 12 ou 13, dans laquelle les poils de la barrette à brosse (16) s'étendent perpendiculairement à une direction d'enfichage d'une rainure d'enfichage (17) de la barrette à brosse (16).

15. Disposition d'armoire de commande selon l'une des revendications 12 à 14, dans laquelle une autre barrette à brosse (16) est enfichée sur une autre tôle de guidage (4) sur une tôle de toit (14) du boîtier d'armoire de commande (1), dans lequel les deux barrettes à brosses (16) sont orientées l'une vers l'autre avec leurs extrémités libres et de préférence sont disposées de manière contiguë entre elles.
